# EUROPEAN PATENT APPLICATION

(11) **EP 2 641 999 A1**
(43) Date of publication of application: **25.09.2013**
(21) Application number: 11842349.0
(22) Date of filing: 09.11.2011
(51) Int. Cl.: C25D 1/04, H05K 1/09

(54) **ELECTROLYTIC COPPER FOIL**

(30) Priority: 15.11.2010 JP 2010254630
(71) Applicant: JX Nippon Mining & Metals Corporation, Tokyo 100-8164 (JP)
(72) Inventor: KOHIKI Michiya, Hitachi-city Ibaraki 317-0056 (JP)
(74) Representative: Liesegang, Eva
(86) International application number: PCT/JP2011/075794
(87) International publication number: WO 2012/066991

(57) **Abstract**

Provided is an electrolytic copper foil having a surface roughness Rz of 2.0 µm or less, wherein a foil thickness difference in the width direction is 1.5% or less. Also provided is the electrolytic copper foil, wherein the foil thickness difference in the width direction is 1.3% or less. Further provided is the electrolytic copper foil, wherein a variation in the roughness in the width direction (Rzmax-Rzmin)/Rzavg is 15% or less. An object of the present invention is to provide an electrolytic copper foil having low surface roughness, wherein the formation of an "elongation wrinkle" and a discolored streak along the length direction is suppressed by allowing the thickness to be uniform in the width and length directions.

## Description

### [Technical Field]

The present invention relates to an electrolytic copper foil, in particular relates to an electrolytic copper foil having a low roughness.

### BACKGROUND

In general, a device for manufacturing an electrolytic copper foil comprises a metal cathode drum and an insoluble metal anode (anode), the metal cathode drum being rotatable and having a mirror polished surface, the insoluble metal anode being arranged at approximately lower half of the metal cathode drum and surrounding the metal cathode drum. A copper foil is continuously manufactured with the device by flowing a copper electrolytic solution between the cathode drum and the anode, applying an electrical potential between these to allow copper to be electrodeposited on the cathode drum, and detaching an electrodeposited copper from the cathode drum when a predetermined thickness is obtained.
A copper foil obtained as described above, which is generally called a raw foil, is used for a copper foil for a negative electrode material of lithium batteries, a copper foil for a printed wiring board and the like as it is or after surface treatment.

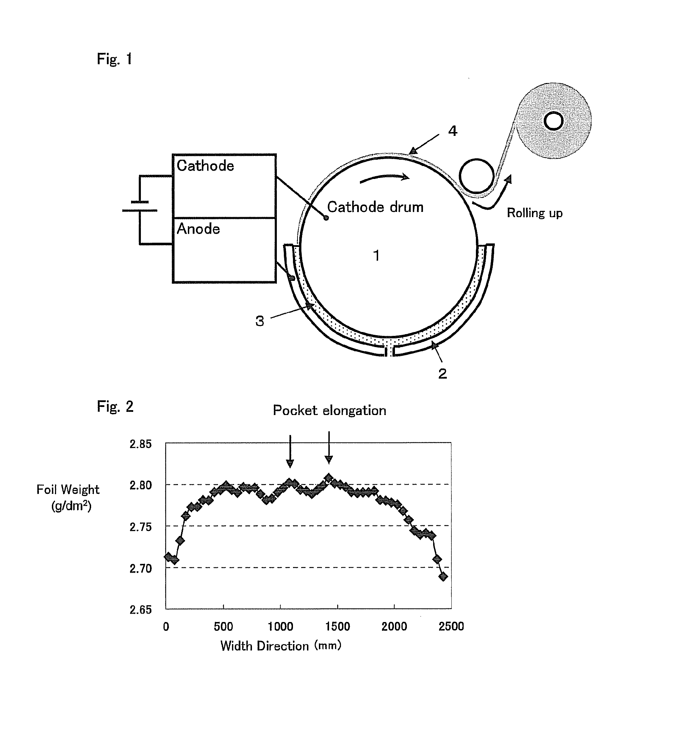

Fig. 1 shows a schematic diagram of the conventional device for manufacturing a copper foil. The device for manufacturing a copper foil comprises Cathode drum 1 provided in an electrolytic bath (not shown) containing an electrolytic solution. Cathode drum 1 rotates under the condition where it is immersed partially (approximately lower half) into the electrolytic solution.
Insoluble metal anode (Anode) 2 is provided such that it surrounds the lower half of the outer circumference of Cathode drum 1. Gap 3 separates Cathode drum 1 and Anode 2 at a certain distance such that the electrolytic solution flows between the two. Two anode plates are provided as shown in Fig. 1.

As shown in Fig. 1, the electrolytic solution supplied from a lower part passes through Gap 3 between Cathode drum 1 and Anode 2, and overflows from an upper edge of Anode 2 to further circulate. A predetermined voltage can be maintained between Cathode drum 1 and Anode 2 through a rectifier.
As Cathode drum 1 rotates, a thickness of copper electrodeposited from the electrolytic solution increases. When a thickness equal to or above a certain value is obtained, raw foil 4 is detached and continuously rolled up. The electrolytic copper foil manufactured as described above has a rough surface having a certain degree of roughness on the side exposed to the electrolytic solution, and a glossy surface on the opposite drum side.

A "wrinkle" has not been a significant problem for the raw foil manufactured as described above when it has a thick foil thickness and a large surface roughness. However, in recent years, an "elongation wrinkle" in a copper foil is becoming a problem because a foil becomes thinner and the roughness becomes lower.
After extensively studying a variation in the foil weight in the width direction for a conventional electrolytic copper foil in order to find what causes the "elongation wrinkle," the present inventors have found that a position where an elongation wrinkle (pocket elongation) is developed shows a variation in foil weight as shown in Fig. 2.

A variation in weight means a variation in a plate thickness. When a plate thickness is thin and a surface roughness is low, the development of pocket elongation becomes significant due to the variation in the plate thickness. This appears to cause the problem. However, a uniform plate thickness has to be considered across the width and length directions, namely, a film thickness over the entire surface of a copper foil has to be considered. In the process of manufacturing an electrolytic copper foil as described above, the plate thickness is very difficult to be precisely controlled, and in particular, a more uniform plate thickness is not easily obtained in the case of a thin foil.

In a case where a small gap between a cathode drum and an anode is maintained while an electrolytic solution flows into the gap to allow electrodeposition, even a device designed for achieving uniformity may often cause a certain variation in a film thickness due to the issues specific to a manufacturing device and operating conditions.
Note that so far the present applicant has made many proposals for solving the problem of a uniform plate thickness in which split anodes are provided at a portion of the anode in the copper foil rolling-up side, and an amount of electric power supplied to these split anodes is individually controlled to arbitrarily adjust a thickness of a copper foil in the width and length directions.
Then many of those are patented (see Patent Literature 1, Patent Literature 2, Patent Literature 3, Patent Literature 4 and Patent Literature 5; Note that the patentees or applicants of these patents have been changed, but all were done by the present applicant). As of today, these are effective.

Further, the technologies which decrease a surface roughness (Patent Literature 6, Patent Literature 7, Patent Literature 8, Patent Literature 9) are also proposed. Each of these is an effective patent and is excellent as a technology at the time. Particularly, the roughness of the rough surface of an electrolytic copper foil has reached Ra of 0.1 µm or less and Rz of 2.0 µm or less.
However, in a case where split anodes are provided at a portion of the anode in the copper foil rolling-up side, and an amount of electric power supplied to these split anodes is individually controlled as in the above mentioned patent literatures in order to achieve a thin plate thickness and a lower surface roughness as well as a uniform thickness in the width and length directions, a problem of an observed discolored streak along the length direction is not solved. Therefore the problem remains to be solved.

Patent Literature 1: Japanese Patent No. 2506573
Patent Literature 2: Japanese Patent No. 2506574
Patent Literature 3: Japanese Patent No. 2506575
Patent Literature 4: Japanese Patent No. 2594840
Patent Literature 5: Japanese Patent No. 3416620
Patent Literature 6: International Publication No. W02005/010239
Patent Literature 7: Japanese Patent Laid-Open No. 2004-107786
Patent Literature 8: International Publication No. W02004/055246
Patent Literature 9: International Publication No. W02004/059040

### SUMMARY OF THE INVENTION

### [Technical Problem]

An object of the present invention is to provide an electrolytic copper foil having a low surface roughness, having a uniform thickness in the width and length directions, but having no "elongation wrinkle," wherein the formation of a discolored streak along the length direction is suppressed.

### [Solution to Problem]

The present inventors have found that the development of an "elongation wrinkle" is caused by a variation in the thickness in the width and length directions and that a supplementary electrode can effectively control the variation in thickness of a copper foil. Further, the present inventors have found that a copper foil having no discolored streak along the length direction can be obtained by appropriately arranging the supplementary electrode.

Accordingly, the present invention provides: 1) An electrolytic copper foil having a surface roughness Rz of 2.0 µm or less, wherein a foil thickness difference in a width direction is 1.5% or less, and no discolored streak along the length direction is present on a surface of the electrolytic copper foil;
2) The electrolytic copper foil according to 1), wherein the foil thickness difference in the width direction is 1.3% or less;
3) The electrolytic copper foil according to 1) or 2), wherein a variation in the roughness in the width direction (Rzmax-Rzmin)/Rzavg is 15% or less.

The present invention provides the following excellent advantageous effects: the present invention does not cause an "elongation wrinkle" at the time of rolling up, and can provide a copper foil having no observable discolored streak along the length direction even in the case of an electrolytic copper foil having a low surface roughness. In particular, since the foil has a low surface roughness and a small variation in the foil thickness, the foil is effective for a copper foil for a negative electrode material of lithium batteries, and, for example, can be applied to a copper foil for a negative electrode material of lithium batteries requiring a tensile strength of 50 to 70 kg/mm² and an elongation of 5 to 9%.

### BRIEF DESCRIPTION OF DRAWINGS

Fig. 1 shows a schematic side view (a cross-sectional view) of a device for manufacturing an electrolytic copper foil comprising a cathode drum and an anode.
Fig. 2 is a graph showing a variation in the foil weight indicating an elongation wrinkle (pocket elongation) in the width direction obtained by the conventional method of manufacturing an electrolytic copper foil.

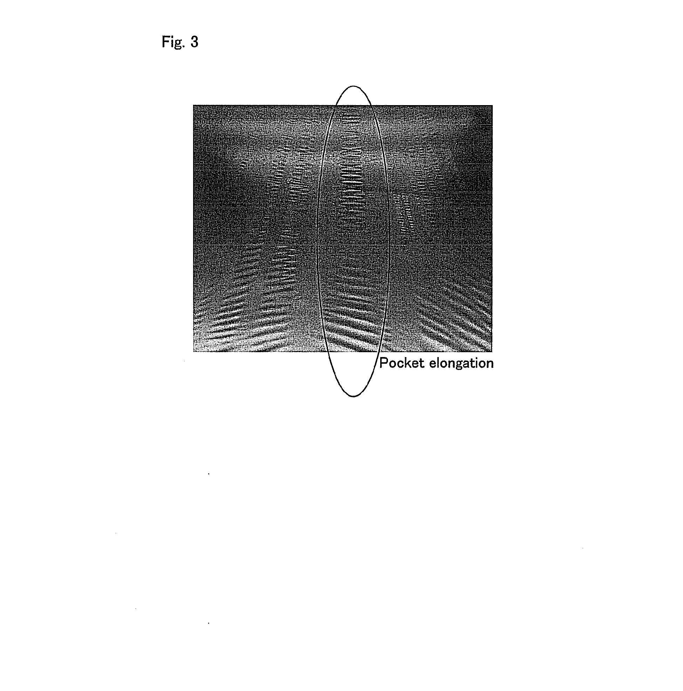

Fig. 3 is an image showing elongation wrinkles (pocket elongation) in the width direction obtained by the conventional method of manufacturing an electrolytic copper foil.
Fig. 4 is a schematic side view (a cross-sectional view) showing an arrangement of a drum, anodes and a supplementary split anode in a device for manufacturing an electrolytic copper foil according to the present invention adapted from the conventional device.
Fig. 5 is a schematic view showing the arrangement of the drum, the anode and the supplementary split anode seen from the supplementary split anode side arranged in the front side of the device according to the present invention.
Fig. 6 is a diagram illustrating a method of measuring the weight of the thickness in the width direction of an electrolytic copper foil and the thickness in the drum circumference direction of the foil.
Fig. 7 shows graphs showing a variation in the foil weight of the thickness in the width direction and the thickness in the drum circumference direction in the method of manufacturing an electrolytic copper foil according to the present invention.
Fig. 8 shows graphs showing a variation in the foil weight of the thickness in the width direction and the thickness in the drum circumference direction in the conventional method of manufacturing an electrolytic copper foil.

### DETAILED DESCRIPTION OF THE INVENTION

Fig. 2 is a graph showing a variation in the foil weight indicating an elongation wrinkle (pocket elongation) in the width direction obtained by the conventional method of manufacturing an electrolytic copper foil. As shown in Fig. 2, a pocket elongation has occurred at the central section in the width of a copper foil.
The present inventors have found that the development of an "elongation wrinkle" is caused by a variation in the plate thickness (a variation in the foil weight) of an electrolytic copper foil in the width direction as shown in Fig. 2. After studying the variation in the plate thickness, the present inventors have found that the development of an elongation wrinkle (pocket elongation) can be suppressed when a foil thickness difference in the width direction is 1.5% or less. Further, more preferably, a foil thickness difference in the width direction is 1.3% or less.
As described in the Patent Literatures, a supplementary electrode provided at the rolling-up side (the rear side) will provide a more uniform plate thickness. However, in the case of a copper foil having a low degree of roughness, discoloring on a surface of a copper foil will be significant.

In view of this, the present invention is characterized in that a supplementary split electrode is provided at the rolling-up side (the rear side) and the opposite side (the front side), and when a variation in thickness is detected in advance in a device for manufacturing an electrolytic copper foil and the supplementary split electrode in the front side is used for adjustment, a copper foil having a uniform plate thickness, having a low degree of roughness, but having no discoloring in the rolling-up side can be manufactured. Further, more preferably, a foil thickness difference is 1.5% or less even in the overall variation including the length direction (the drum circumference direction).

Note that the surface roughness of a copper foil is preferably 2.0 µm or less in Rz. More preferably, it is 1.6 µm or less. Although the cause of discoloring is not cleared up, concerning copper layer electrodeposited particles to be adjusted by the supplementary split electrode, since the state of copper layer electrodeposited particles formed differs among the individual split electrodes, when the thickness is adjusted at the rear side as described in the Patent Literatures, a final plating layer will be formed by the supplementary split electrodes, which results in the variation of plating adherence patterns (roughness) among the supplementary split electrodes since each has different surface state among the split electrodes, thereby developing an unwanted discolored streak on a surface of the copper foil.

However, the adjustment at the early stage of copper layer electrodeposition using the supplementary split electrode provided in the front side and electrodeposited particles subsequently formed by the anode can make up for subtle differences in the patterns of the copper layer electrodeposited particles formed by the supplementary split electrode, resulting in a preferred state of a uniform surface. Specifically, for the roughness which does not cause discoloring on a surface of a copper foil, a variation in the roughness in the width direction (Rzmax-Rzmin)/Rzavg is 15% or less.
That is, the variation in the roughness in the width direction (Rzmax-Rzmin)/Rzavg can be controlled to be 15% or less by providing a supplementary split electrode in the front side.

Such an electrolytic copper foil and a method of manufacturing thereof will be described specifically below. A basic structure of a device for manufacturing an electrolytic copper foil according to the present invention is shown in Fig. 1. As shown in Fig. 1, it comprises Cathode drum 1 and Anode 2, Cathode drum 1 being rotatable, Anode 2 having an arc-like shape, opposing to Cathode drum 1 and surrounding a portion of the circumference (approximately lower 1/4).
An electrolytic bath contains a copper sulfate solution to be used as a copper electrolytic solution. The concentration, temperature, pH and the like of the copper electrolytic solution are adjusted to perform good electrodeposition and the copper electrolytic solution is circulated and reused. A conventional electrolytic solution can be used as the present electrolytic solution.
Cathode drum 1 is immersed partially in the electrolytic solution and rotated clockwise as shown in Fig. 1. As described above, Anode 2 is separated from the surface of Cathode drum 1 by a certain distance, and, for example, placed around Cathode drum 1 in an arc-like fashion.

Cathode drum 1 uses, for example, a stainless steel or titanium rotatable cylindrical body. Anode 2 uses an insoluble anode, which is made of lead, a lead-antimony alloy, a silver-lead alloy, an indium-lead alloy and the like. A material generally called DSE or DSA in which platinum group or an oxide thereof is coated on a valve metal such as titanium can be used.
Anode 2 is shown in pairs (A1, A2) in Fig. 1, but two or more pieces may be used so that Cathode drum 1 is covered over. The gap between Cathode drum 1 and Anode 2 is usually kept in a fixed position in the range between 2 and 100 mm or less. Although a smaller gap results in a less amount of electricity, a plate thickness and quality are difficult to be controlled. Thus, the above range is preferred.

The gap between Cathode drum 1 and Anode 2 serves as a flow passageway of an electrolytic solution. As shown in Fig. 1, an electrolytic solution supplied via a pump in the bath passes through Gap 3 between Cathode drum 1 and Anode 2, and overflows from the upper edge of Anode 2.
A predetermined voltage can be maintained between Cathode drum 1 and Anode 2 via a rectifier. The thickness of copper electrodeposited from the electrolytic solution increases on Cathode drum 1 as Cathode drum 1 rotates. As shown in Fig. 1, when a certain thickness is obtained, Raw foil 4 is detached from Cathode drum 1, and continuously rolled up with a roll-up unit (not shown).

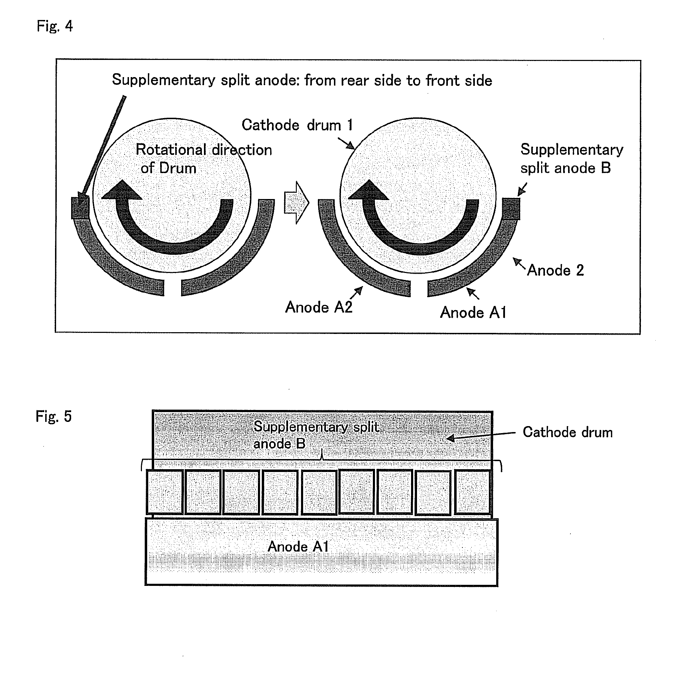

Furthermore, as shown in Fig. 4, the device for manufacturing an electrolytic copper foil of the present invention comprises Supplementary split anode B as an anode for uniformity at the side wall (upper edge) of Anode 2 in the opposite side (the front side) from the copper foil rolling-up side (the rear side), Supplementary split anode B being opposed to Cathode drum 1.
That is, in a device for manufacturing an electrolytic copper foil, comprising Cathode drum 1 which is immersed partly in a copper electrolytic solution and rotatable; Anode 2 which is opposed to Cathode drum 1 and surrounds a part of the circumference thereof; a unit for electrodepositing copper on Cathode drum 1 by flowing a copper electrolytic solution between Cathode drum 1 and Anode 2; and a unit for detaching an electrodeposited copper foil from the cathode drum, provided are Supplementary split anode B opposed to Cathode drum 1 located at the side wall of Anode 2 in the opposite side from the copper foil rolling-up side; and a unit for individually controlling an amount of electricity supplied to Anode 2 and Supplementary split anode B.

Supplementary split anode B is further separated in the width direction, and an amount of electricity can be individually controlled for each. Further, Anode 2 may comprise two anodes: Anode A1 and A2. In this case, a unit can be provided to individually control an amount of electricity supplied to Supplementary split anode B provided at the side wall (upper edge) of Anode A1 in the opposite side from Anode A2 located in the copper foil rolling-up side of Anode A1 and A2.

Fig. 5 is a schematic view showing the arrangement of Cathode drum 1, Anode A1 and Supplementary split anode B seen from the side of the supplementary split anode. The length in the width direction of Supplementary split anode B can be approximately the same as that of Anode A1, but the length can be adjusted as appropriate. Further, it is preferably attached to Anode A1 for secure holding in an easily detachable fashion using, for example, a bolt.
An amount of electricity for Supplementary split anode B and Anode A1 is allowed to be individually controlled. Therefore, Supplementary split anode B is attached to Anode A1 via a fixing member capable of electrical insulation.

The amount of electricity supplied to Supplementary split anode B is adjusted so that an electrolytic copper foil is manufactured having a low surface roughness and a uniform thickness in the width and length directions, and the formation of an "elongation wrinkle" and a discolored streak along the length direction is suppressed.
Further, an advantage is that the improvement in a device by providing Supplementary split anode B can be easily implemented in an existing device for manufacturing an electrolytic copper foil.

When the device for manufacturing an electrolytic copper foil of the present invention is used for electrolysis, a foil thickness difference in the width direction of an electrolytic copper foil of 1.5% or less can be achieved. This solves the problem which has been difficult to control so far. That is, by providing a supplementary split electrode in the front side, a variation in the plate thickness (a change in foil weight) in the width direction of an electrolytic copper foil can be controlled, a foil thickness difference in the width direction of 1.5% or less can be achieved, and the development of an elongation wrinkle (pocket elongation) can be suppressed.
Note that a condition for the present invention is a low roughness copper foil having a surface roughness Rz of 2.0 µm or less. More preferably, it is 1.6 µm or less.

As described below, a foil thickness difference in the width direction of 1.5% or less allows both a uniform thickness in the width direction and a uniform thickness in the drum circumference direction at the same time. The supplementary split electrode serves to adjust electrodeposited particles subsequently formed in the early stage of copper layer electrodeposition, and continues to perform its function in turn. Therefore, a uniform thickness in the width direction inevitably result in a function to cause a uniform thickness of a copper layer along the drum circumference direction, i.e., across the length direction of the copper foil.
Further, by providing a supplementary split electrode in the front side, the influence from the copper layer electrodeposited particles formed by the supplementary split electrode will be avoided, allowing a small variation in the roughness in the width direction since electrodeposited particles are uniformly formed by the anode on the entire surface over the electrodeposited particles previously formed by the supplementary split electrode. That is, (Rzmax-Rzmin)/Rzavg can be controlled to be 15% or less.

Next, specific examples of the present invention will be described below in comparison with the conventional art. Note that the specific examples are merely examples, and the present invention is not limited to these examples. That is, all aspects or modifications not described in Examples which are within the scope of the spirit of the present invention are encompassed.

With regard to Examples 1 to 5, a device comprising Supplementary split anode B provided at the side wall (upper edge) of Anode A1 in the opposite side from Anode A2 in the copper foil rolling-up side of Anode 2 and a unit for individually controlling an amount of electricity supplied to Supplementary split anode B was used to produce electrolytic copper foils with various thicknesses.
In contrast, with regard to Comparative Examples 6 to 10, the supplementary split anode was not provided, with regard to Comparative Examples 11 to 15, the supplementary split anode was provided at the copper foil rolling-up side as in the Patent Literatures 1 to 3 to produce electrolytic copper foils with various thicknesses.

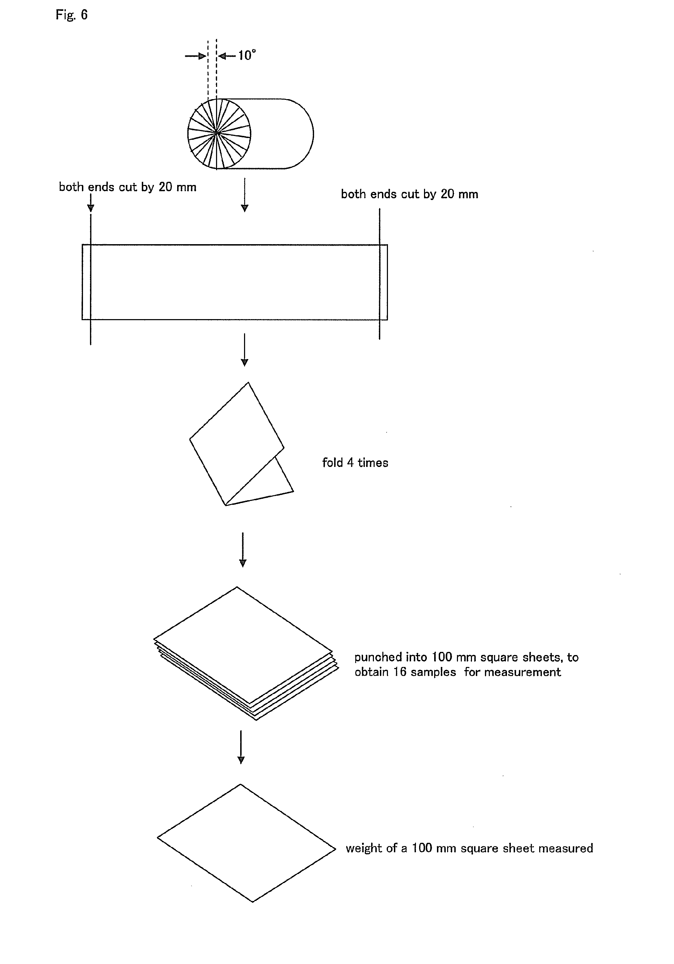

The weight (change) associated with a variation in the thickness in the width direction and the thickness in the drum circumference direction (the length direction of a copper foil) of an electrolytic copper foil can be measured, for example, as shown in Fig. 6. That is, in the case of 36 point gravimetry, a reference point is marked every 10° along the drum circumference direction. Next, the sample was cut at every 3 reference points (186 mm), and both ends of each cut sample were further cut by 20 mm.
Next, this cut foil is folded 4 times, and divided into 16. This is punched to a 100 mm square sheet, and the weight of this 100 mm square sheet is measured. Further, the electrodeposited side of each sheet is measured for a surface roughness Rz. The mean value of Rz for each sheet is called Rzavg, and the maximum value and the minimum value among the measured values are called Rzmax and Rzmin, respectively.

Measurements of the weight of the thickness in the width direction of a foil and the thickness in the drum circumference direction of the foil can be measured by other methods, but this method is an actually suitable gravimetric method. The gravimetric measurements shown in Fig.s 7 and 8 are performed using this approach.
Further, the development of an elongation wrinkle was evaluated at the time of rolling-up, and the presence of a discolored streak was evaluated by the cut sample at the end. Note that one of ordinary skill in the art can easily determine the presence of a discolored streak by comparing a base region with a discolored region in the same sample having a discolored streak.
The results are shown in Table 1.

[Table 1]

| | No. | Nominal thickness | Supplementary split anode | Variation in the thickness in the width direction (%) | Elongation wrinkle | Discoloring |
|---|---|---|---|---|---|---|
| Example | 1 | 35 µm | Front side | 0.89 | not found | not found |
| | 2 | 20 µm | Front side | 0.87 | not found | not found |
| | 3 | 12 µm | Front side | 0.88 | not found | not found |
| | 4 | 10 µm | Front side | 0.79 | not found | not found |
| | 5 | 8 µm | Front side | 0.83 | not found | not found |
| Comparative Example | 6 | 35 µm | - | 1.75 | found | not found |
| | 7 | 20 µm | - | 1.80 | found | not found |
| | 8 | 12 µm | - | 1.77 | found | not found |
| | 9 | 10 µm | - | 1.79 | found | not found |
| | 10 | 8 µm | - | 1.74 | found | not found |
| | 11 | 35 µm | Rear side | 0.91 | not found | found |
| | 12 | 20 µm | Rear side | 0.85 | not found | found |
| | 13 | 12 µm | Rear side | 0.86 | not found | found |
| | 14 | 10 µm | Rear side | 0.82 | not found | found |
| | 15 | 8 µm | Rear side | 0.84 | not found | found |

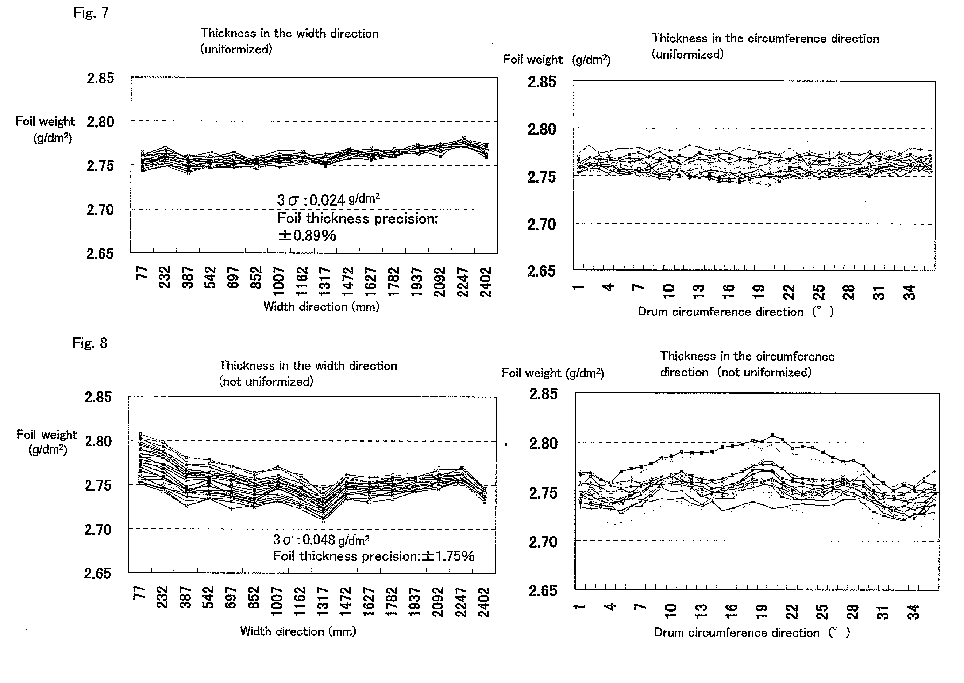

Fig. 7 shows graphs showing a variation in the foil weight of the thickness in the width direction and the thickness in the drum circumference direction in Example 1. According to this, the variation in the foil weight of both the thickness in the width direction and the thickness in the drum circumference direction showed a small variation of 0.05 g/dm² or less. In Examples 2 to 5, the variation in the foil weight of both the thickness in the width direction and the thickness in the drum circumference direction also showed a small variation.
The variation (%) in the thickness in the width direction of a copper foil, namely, the foil thickness difference in the width direction of a copper foil is shown in Table 1. In Examples 1 to 5, the variation was in the range between 0.79 and 0.89%. As a result, an "elongation wrinkle" did not occur even at the time of rolling-up in Examples 1 to 5. Further, no discolored streak was found in all of Examples.

On the other hand, Fig. 8 shows graphs showing a variation in the foil weight of the thickness in the width direction and the thickness in the drum circumference direction in the case of Comparative Example 6, i.e. in the case where Supplementary split anode is not provided.
As shown in Fig. 8, the variation in the foil weight of both the thickness in the width direction and the thickness in the drum circumference direction shows a large variation of almost 0.10 g/dm².

In Comparative Examples 7 to 10, the variation in the foil weight of both the thickness in the width direction and the thickness in the drum circumference direction also showed a large variation. As shown in Table 1, in Comparative Examples 6 to 10, the variation in the thickness in the width direction of a copper foil, namely, the foil thickness difference in the width direction of a copper foil is in the range between 1.74 and 1.80%, which is larger than that in Examples. In Comparative Examples 6 to 10, as a result, an "elongation wrinkle" occurred at the time of rolling-up. Note that no discolored streak along the length direction (in the drum circumference direction) of a copper foil was observed. The results are also shown in Table 1.

In Comparative Examples 11 to 15, in which a supplementary split anode was provided in the rear side (in the copper foil rolling-up side) by way of contrast, the variation in the foil weight of both the thickness in the width direction and the thickness in the drum circumference direction showed a variation as small as those in Examples. That is, as shown in Table 1, the variation in the thickness in the width direction of a copper foil, namely, the foil thickness difference in the width direction of a copper foil was in the range between 0.82 and 0.91%, showing no "elongation wrinkle" at the time of rolling-up. However, a discolored streak along the length direction, i.e. the drum circumference direction) of a copper foil was observed. The results are also shown in Table 1. This reveals that providing a supplementary split anode in the rear side is not expedient.

As described above, the advantages according to the present invention are as follows: the foil thickness precision can be improved; the development of an "elongation wrinkle" can be suppressed by a uniform foil thickness in the width and length directions; and the development of a discolored streak along the length direction can be suppressed even if a surface roughness is low.

### [Industrial Applicability]

The advantageous effects of the present invention are able to suppress the development of an "elongation wrinkle" by a uniform thickness in the width and length directions and the development of a discolored streak along the length direction even in an electrolytic copper foil having a low surface roughness. Therefore, it can be used as a copper foil for a negative electrode material of lithium batteries, and a copper foil for a printed wiring board in which a thin copper foil suitable for a denser electronic circuit, a narrower circuit width and multi-layering is required. In particular, it is useful for a copper foil for a negative electrode material of lithium batteries in which a tensile strength of 50 to 70 kg/mm², and an elongation of 5 to 9%, for example, are required since it has a low surface roughness and a small variation in the foil thickness.

### References Signs List

- 1: Cathode drum
- 2: Anode (A1, A2)
- 3: Gap
- 4: Raw foil

## Claims

1. An electrolytic copper foil having a surface roughness Rz of 2.0 µm or less, wherein a foil thickness difference in a width direction is 1.5% or less, and no discolored streak is present along a length direction on a surface of the copper foil.

2. The electrolytic copper foil according to claim 1, wherein the foil thickness difference in the width direction is 1.3% or less.

3. The electrolytic copper foil according to claim 1 or 2, wherein a variation in the roughness in the width direction (Rzmax-Rzmin)/Rzavg is 15% or less.
